# EUROPEAN PATENT SPECIFICATION

(11) **EP 1 553 670 B1**
(45) Date of publication and mention of the grant of the patent: **04.02.2009**
(21) Application number: 04257083.8
(22) Date of filing: 16.11.2004
(51) Int. Cl.: H01S 5/343, H01S 5/183, H01S 5/323

(54) **Semiconductor device having a quantum well structure including dual barrier layers, semiconductor laser employing the semiconductor device and methods of manufacturing the semiconductor device and the semiconductor laser.**
Halbleiterbauelement mit einer Quantentopfstruktur mit doppelten Barriereschichten, Halbleiterlasergerät basierend auf dem Halbleiterbauelement und Herstellungsverfahren für das Halbleiterbauelement und das Halbleiterlasergerät.
Dispositif à semi-conducteur avec une structure à puits quantiques ayant des couches barrières doubles, dispositif laser à semi-conducteur utilisant ce dispositif à semi-conducteur et procédés de fabrication associés.

(30) Priority: 10.01.2004 KR 2004001805
(43) Date of publication of application: 13.07.2005
(73) Proprietor: SAMSUNG ELECTRONICS CO., LTD., Suwon-si, Gyeonggi-cho (KR)
(72) Inventor: Kim, Ki-sung, Jangan-gu, Suwon-si, Gyeonggi-do (KR)
(74) Representative: Greene, Simon Kenneth

(56) References cited:
- US-A1- 2003 197 188
- US-A1- 2003 219 917
- PATENT ABSTRACTS OF JAPAN vol. 2003, no. 09, 3 September 2003 (2003-09-03) -& JP 2003 142784 A (FURUKAWA ELECTRIC CO LTD:THE), 16 May 2003 (2003-05-16)

## Description

The present invention relates to a semiconductor device, and more particularly, to a semiconductor device having a quantum well structure the emission wavelength of which can be adjusted by varying the thicknesses and compositions of a plurality of barrier layers, a semiconductor laser using the semiconductor device, and methods of manufacturing the semiconductor device and the semiconductor laser.

Recently, optics have been actively studied in order to develop high-speed data communications technology with various applications including laser printers, optical image storage, underground optical cable systems, and optical communications. For example, owing to such development in the field of optical communications, large antennas established on the ground to transmit electromagnetic waves through the air have been replaced with underground optical cables that transmit a large amount of information in the form of optical signals.

In response to increased demand for a high-speed, inexpensive communication system, an optical fiber with an optical transmission band of longer wavelengths has been developed. Currently, an optical fiber that can be used in a wavelength range from 1.3 µm to 1.5 µm is under development. To implement high-speed information transmission using optical fibers, information needs to be properly converted into an optical signal. To this end, a laser oscillation signal having a wavelength within an optical transmission band of the optical fiber is required. Accordingly, efforts have been made to improve a laser diode in order to oscillate a laser signal having a wavelength within an optical transmission band of the optical fiber.

Such efforts have involved varying the internal composition and interfacial structures of a device for performance enhancement, size reduction and to reduce heat generation and power consumption. One result is the development of a GaAs-based vertical cavity surface emitting laser (VCSEL) diode that costs low and can be easily combined with an optical fiber.

A study finding that long-wavelength laser oscillation can be achieved by adding nitrogen to a GaAs-based VCSEL is reported by M. Kondow, et al. in February, 1996 (Jpn. J. Appl. Phys., Vol. 35 (1996), pp. 1273 - 1275, Part 1, No. 2B, "GalnNAs: A Novel Material for Long-Wavelength-Range Laser Diodes with Excellent High-Temperature Performance").

After the publication of Kondow's paper disclosing that long-wavelength emission can be achieved by adding a small amount of nitrogen to the InGaAs material, due to the requirement for optical communications parts to be used in a metro area network (MAN), 1.3 µm-wavelength semiconductor lasers using GaInNAs have been actively developed. However, if GaAs is used for a barrier and GaInNAs is used for a well, the emission wavelength is shifted to a longer wavelength band as the concentration of nitrogen in the quantum well structure increases, but optical characteristics dramatically deteriorate. Accordingly, a quantum well with excellent emission efficiency even in the wavelength band of 1.25 µm can not be obtained with such a GaAs/GaInNAs quantum well structure.

As a possible solution to the problem described above, a semiconductor laser with a GaAs/GaInNAs quantum well structure having a quantum well barrier composed of GaNAs instead of GaAs was suggested (IEEE, LEOS2001 Annual meeting [proceeding Vol. pp. 12 - 13], "Long wavelength GaInNaAs ridge waveguide lasers with GaNAs barriers" by J. Harris, et al. The semiconductor laser suggested by Harris, et al. uses GaNAs as a barrier to reduce an energy gap between the barrier and the quantum well and shift the emission wavelength of the quantum well to a longer wavelength band. In this structure, as a layer of GaNAs becomes thicker, the emission wavelength of the quantum well made of GaInNAs is shifted to a longer wavelength range.

However, when a quantum well barrier is made of GaNAs, as in the GaAs/GaInNAs quantum well structure, the crystal quality rapidly deteriorates as the concentration of nitrogen increases or the quantum well barrier gets thicker.

In order to solve this problem, a 1.3-µm semiconductor laser that uses GaP with tensile strength as a barrier is suggested in Applied Physics Letters Vol. 83, No. 1, "High-Performance and High-Temperature Continuous-Wave-Operation 1300 nm InGaAsN Quantum Well Lasers by Organometallic Vapor Phase Epitaxy" by N. Tansu, et al.

According to N. Tansu, et al., when a Group-III semiconductor material is grown on a GaAs semiconductor substrate, the band gap can be adjusted according to the ratio of As/P, and tensile strain is easy to control. However, in a deposition process using metal-organic chemical vapor deposition (MOCVD), since an As source and a P source are supplied to the same reaction vessel, the inside of the reaction vessel is easily contaminated. Therefore, reproducible deposition is not ensured.

US 2003/0219917 describes a process for making VCSEL structures including quantum wells. GaAs barrier layers are used to prevent Al and N from combining.

JP 2003-142784 describes a VCSEL structure using a GaNAs/AlGaNAs superlattice barrier

A more complicated barrier with multiple quantum wells is taught by US 2003/0197188.

According to an aspect of the present invention, there is provided a semiconductor device according to claim 1.

According to another aspect of the present invention, there is provided a method of manufacturing a semiconductor device according to claim 13.

The present invention provides a semiconductor device having a quantum well structure with an emission wavelength of at least 1.3 µm and a method of manufacturing the semiconductor device.

The present invention also provides a vertical cavity surface emitting laser (VCSEL) having a quantum well structure with an emission wavelength of at least 1.3 µm and a method of manufacturing the VCSEL.

The present invention further provides an edge-emitting semiconductor laser having a quantum well structure with an emission wavelength of at least 1.3 µm and a method of manufacturing the edge-emitting semiconductor laser.

The above and other features and advantages of the present invention will become more apparent by describing in detail exemplary embodiments thereof with reference to the attached drawings in which:
FIGS. 1 and 2 are a cross-sectional view and an energy band diagram, respectively, illustrating an edge-emitting semiconductor laser according to an embodiment of the present invention;
FIGS. 3 and 4 are a cross-sectional view and an energy band diagram, respectively, illustrating a quantum well structure according to another embodiment of the present invention;
FIGS. 5 and 6 are a cross-sectional view and an energy band diagram, respectively, illustrating a quantum well structure according to another embodiment of the present invention;
FIGS. 7 and 8 are a cross-sectional view and an energy band diagram, respectively, illustrating a quantum well structure according to another embodiment of the present invention;
FIGS. 9 and 10 are cross-sectional views illustrating a vertical cavity surface emitting laser and it's active region according to another embodiment of the present invention;
FIG. 11 is a graph illustrating the wavelength of light emitted from a quantum well structure according to the present invention when the thickness of a InGaAs layer is fixed and the thickness of a GaNAs layer is varied;
FIG. 12 is a graph illustrating the wavelength of light emitted from another quantum well structure according to the preset invention when the thickness of the GaNAs layer is fixed and the thickness of the InGaAs layer is varied;
FIG. 13 is a graph of an emission wavelength versus the amount of indium (In) in the InGaAs layer; and
FIG. 14 is a graph of an emission wavelength versus the amount of nitrogen (N) in the GaNAs layer.

Embodiments of a semiconductor structure having a quantum well structure with dual barrier layers, a semiconductor laser employing the semiconductor structure, and a method of manufacturing the semiconductor laser will be described in detail with reference to the accompanying drawings. In the drawings, common elements are denoted by identical reference numerals.

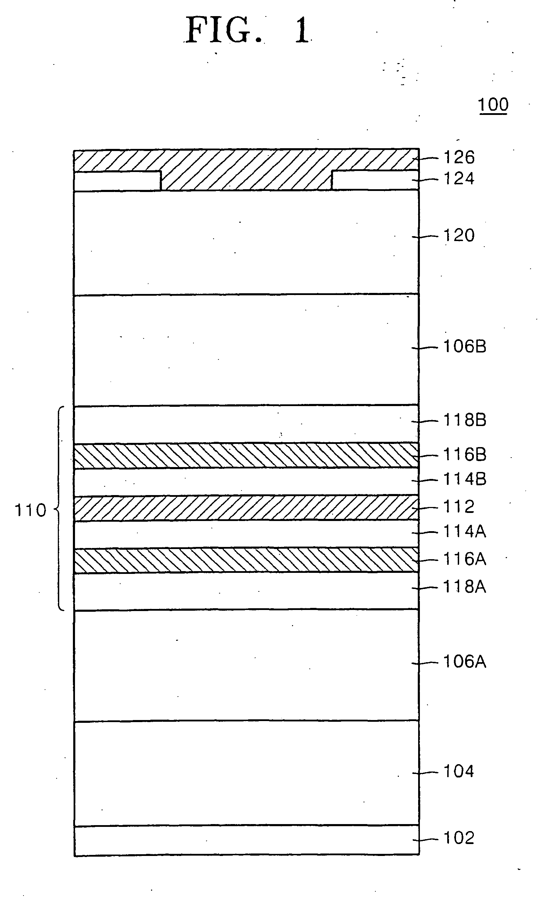

FIG. 1 is a cross-sectional view illustrating an edge-emitting semiconductor laser according to an embodiment of the present invention. As shown in FIG. 1, an edge-emitting semiconductor laser 100 includes a semiconductor substrate 104, an n-type electrode 102 formed on a lower surface of the semiconductor substrate 104, a lower cladding layer 106A formed on an upper surface of the semiconductor substrate 104, an active region 110 formed on the lower cladding layer 106A, an upper cladding layer 106B formed on the active region 110, a contact layer 120 formed on the upper cladding layer 106B, and a p-type electrode 126 formed on the contact layer 120.

In addition, the active region 110 includes a central barrier layer 112, a lower quantum well layer 114A, an upper quantum well layer 114B, a first lower barrier layer 116A, a first upper barrier layer 116B, a second lower barrier layer 118A, and a second upper barrier layer 118B. The central barrier layer 112 is formed of GaAs in the middle of the active region 110. The second lower barrier layer 118A, the first lower barrier layer 116A, and the lower quantum well layer 114A are formed sequentially between the central barrier layer 112 and the lower cladding layer 106A. The upper quantum well layer 114B, the first upper barrier layer 116B, and the second upper barrier layer 118B are formed sequentially between the central barrier layer 112 and the upper cladding layer 106B.

The semiconductor substrate 104 is made of an n-type GaAs-based semiconductor material. Various layers may be grown on the semiconductor substrate 104 to easily form a GaAs-based quantum well. The lower cladding layer 106A is n-type and is formed to a thickness of 1,800 nm (18,000 Å) using, for example, AlGaAs. The upper cladding layer 106B is p-type and is formed to a thickness of 1,800 nm (18,000 Å) using, for example, AlGaAs.

The contact layer 120 is p-type and is formed to a thickness of 80 nm (800 Å) using, for example, GaAs. The n-type electrode 102 and the p-type electrode 126 are used to excite an active region 110. The n-type electrode 102 is made of AuGe and the p-type electrode 126 is made of Ti.

The edge-emitting semiconductor laser 100 according to a first embodiment of the present invention is a striped type. In order to apply a current across striped regions of the active region 110, an insulating layer 124 made of SiO₂ is formed on the contact layer 120, and then the insulating layer 124 is patterned as stripes.

Although not illustrated in the drawings, in order to improve an ohmic contact between the p-type electrode 126 and the p-type contact layer 120, a metal contact layer formed of Ti or Pt or as a stack of Ti and Pt, may be further formed. In order to improve an ohmic contact between the n-type electrode 102 and the semiconductor substrate 104, a metal contact layer formed of Ni or Au or as a stack of Ni and Au, may be further included.

In the first embodiment of the present invention, the p-type electrode 126 of the edge-emitting semiconductor laser is designed to apply a current across striped regions of the active region. However, the p-type electrode 126 of the edge-emitting semiconductor laser can be designed to apply a current across the entire active region. In addition, although the active region 110 is not formed in the shape of stripes, the edge-emitting semiconductor laser is configured to have the active region 110 match the shape of the p-type electrode 126 formed on an open portion of the insulating layer 124.

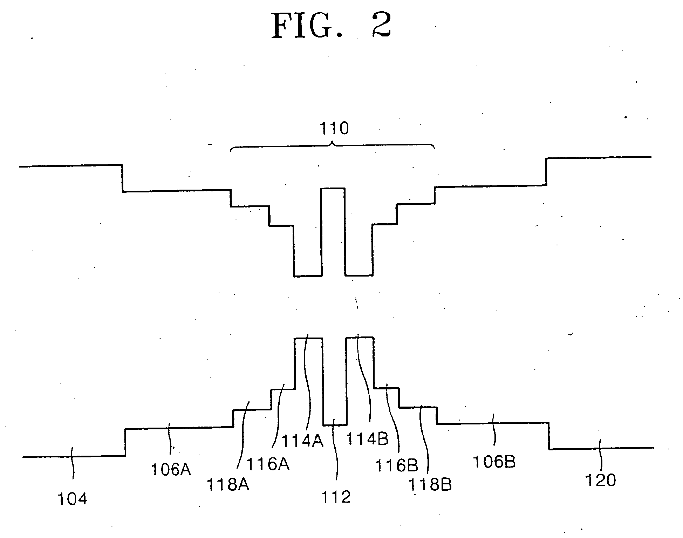

FIG. 2 is an energy band diagram of the edge-emitting semiconductor laser according to the first embodiment of the present invention.

As shown in FIG. 2, the lower quantum well layer 114A and the upper quantum well layer 114B, which are used in the active region 110 of the edge-emitting semiconductor laser 100 according to the first embodiment of the present invention, are made of GaₓIn₁₋ₓN_{y}As_{1-y} where x and y are greater than 0 and less than 1 to a thickness of 2-10 nm. In the first embodiment of the present invention, x is 0.65 and y is 0.01.

Meanwhile, the first lower barrier layer 116A and the first upper barrier layer 116B are made of InₓGa₁₋ₓAs where x is greater than 0 and less than 1 to a thickness of 0.1- 50 nm. In the first embodiment of the present invention, x is 0.35.

In addition, the second lower barrier layer 118A and the second upper barrier layer 118B are made of GaNₓAs₁₋ₓ where x is greater than 0 and less than 1 to a thickness of 0.1- 20 nm. In the first embodiment of the present invention, x is 0.02.

Additionally, the central barrier layer 112 is made of GaAs to a thickness of 0-50 nm.

According to the first embodiment of the present invention, the wavelength of a laser beam emitted in the lower quantum well layer 114A and the upper quantum well layer 114B of the active region 110 may be controlled to be at least 1.2 µm by varying the composition and the thickness of the first barrier layers 116A and 116B and the second barrier layers 118A and 118B. In addition, the degree and form of a compressive strain induced in the lower quantum well layer 114A and the upper quantum well layer 114B may be controlled by varying the composition of indium (In) in the first lower and upper barrier layers 116A and 116B.

In addition, the degree and form of a tensile strain induced in the lower quantum well layer 114A and the upper quantum well layer 114B may be controlled by varying the composition of N in the second lower and upper barrier layers 118A and 118B. Also, the degree and form of the compressive strain or tensile strain induced in the lower quantum well layer 114A and the upper quantum well layer 114B can be controlled by varying the thickness of the first barrier layers 116A or the second barrier layers 116B.

According to the first embodiment of the present invention, the wavelength of the laser beam may be controlled by varying the composition or thickness of the first barrier layers 116A and 116B and the second barrier layers 118A and 118B. Accordingly, even if the crystalline form of the quantum well layers 114A and 114B is deteriorated by the first barrier layers 116A and 116B, the crystalline form of the quantum well layers 114A and 114B can be dramatically improved by appropriately deforming the second barrier layers 118A and 118B.

As a result, in the first embodiment of the present invention, the wavelength of the laser beam emitted in the quantum well layers may be controlled to be 100 nm or greater without deterioration of optical characteristics by varying the composition and thickness of the first barrier layers and the second barrier layers that have the same structures as the quantum well layers.

Although in the first embodiment of the present invention the quantum well layers are formed as a dual layer, an edge-emitting semiconductor layer including a plurality of quantum well layers, i.e., more than two quantum well layers, between the lower and upper cladding layers 106A and 106B may be manufactured.

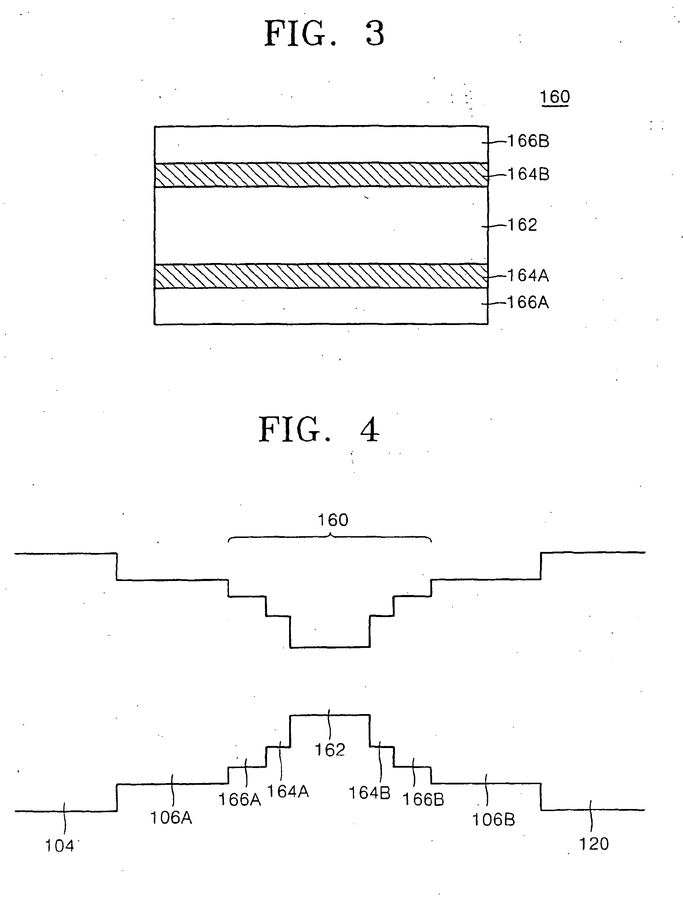

FIGS. 3 and 4 are a cross-sectional view and an energy band diagram, respectively, of a quantum well structure according to another embodiment of the present invention. In the second embodiment, the configurations and functions of all components except for the active region are identical to the first embodiment.

The active region 160 used in the second embodiment of the present invention has a single quantum well structure instead of a multi-quantum well structure. The quantum well layer 162 formed at the center of the active region 160 is 2 - 10 nm thick and is made of GaₓIn₁₋ₓN_{y}As_{1-y} where x and y are greater than 0 and less than 1. In the second embodiment, x is 0.65 and y is 0.01.

Meanwhile, the first lower barrier layer 164A and the first upper barrier layer 164B are made of InₓGa₁₋ₓAs where x is greater than 0 and less than 1 to a thickness of 0.1 - 50 nm. In the second embodiment of the present invention, x is 0.35.

Additionally, the second lower barrier layer 166A and the second upper barrier layer 166B are made of GaNₓAs₁₋ₓ, where x is greater than 0 and less than 1, to a thickness of 0.1 - 50 nm. In the second embodiment of the present invention, x is 0.02.

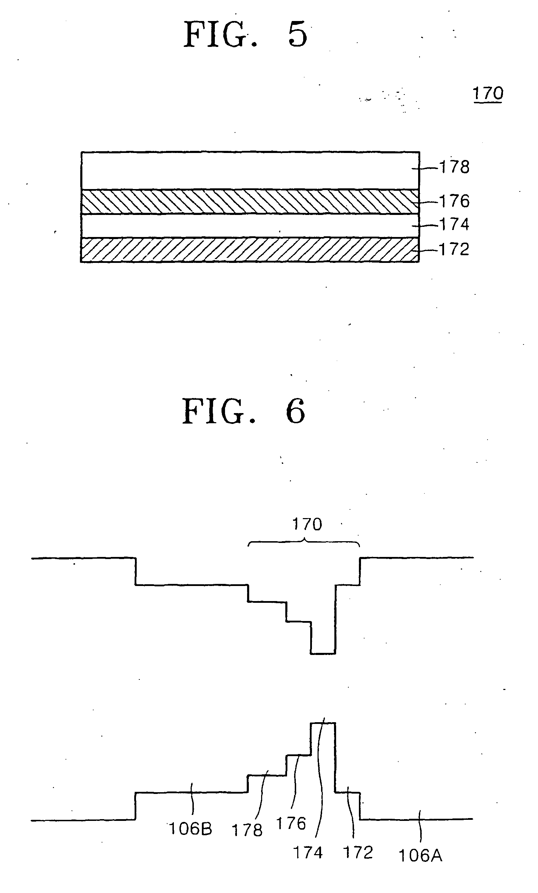

FIGS. 5 and 6 are a cross-sectional view and an energy band diagram, respectively, of a quantum well structure according to a third embodiment of the present invention. An active region 170 used in the third embodiment of the present invention includes a first barrier layer 176 and a second barrier layer 178, which are not symmetrical with respect to a quantum well layer 174, as shown in FIG. 5. The quantum well layer 174 is made of GaₓIn₁₋ₓN_{y}As_{1-y}, where x and y are greater than 0 and less than 1, to a thickness of 2 - 10 nm. In the third embodiment of the present invention, x is 0.65 and y is 0.01.

According to the third embodiment, an auxiliary barrier 172 is formed of GaAs under the quantum well layer 174 to a thickness of 0 - 500 nm.

Meanwhile, the first barrier layer 176 is 0.1 - 50 nm thick and is made of InₓGa₁₋ₓAs, where x is greater than 0 and less than 1. In the third embodiment of the present invention, x is 0.35.

Additionally, the second barrier layer 178 is formed of GaNₓAs₁₋ₓ, where x is greater than 0 and less than 1, only on the first upper barrier 176 to a thickness of 0.1 - 20 nm. In the third embodiment of the present invention, x is 0.02.

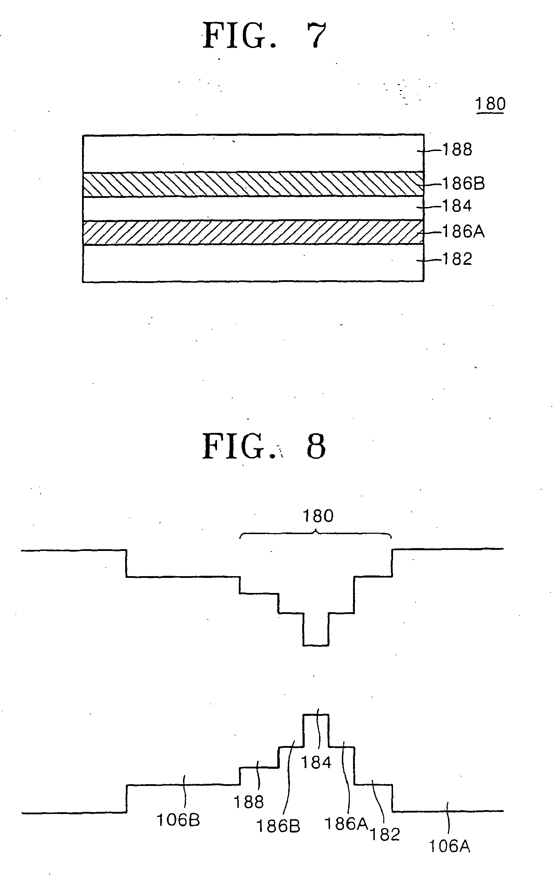

FIGS. 7 and 8 are a cross-sectional view and an energy band diagram, respectively, of a quantum well structure according to a fourth embodiment of the present invention. A quantum well layer 184 of an active region 180 in an edge-emitting semiconductor laser according to the fourth embodiment of the present invention is made of GaₓIn₁₋ₓN_{y}As_{1-y}, where x and y are greater than 0 and less than 1, to a thickness of 2-10 nm. In the fourth embodiment, x is 0.65 and y is 0.01.

Meanwhile, the first lower barrier layer 186A and the first upper barrier layer 186B are made of InₓGa₁₋ₓAs, where x is greater than 0 and less than 1, to a thickness of 0.1-50 nm. In the fourth embodiment of the present invention, x is 0.02.

Additionally, the second lower barrier layer 182 is made of GaAs to a thickness of 0-500 nm. The second upper barrier layer 188 is made of GaNₓAs₁₋ₓ, where x is greater than 0 and less than 1, to a thickness of 0.1- 20 nm. In the fourth embodiment of the present invention, x is 0.02.

The fourth embodiment of the present invention differs from the first embodiment in that the composition and thickness of the first lower barrier layer 186A and the first upper barrier layer 186B are varied to induce compressive strain to the quantum well layer 184 but only the second upper barrier layer 188 is used to induce tensile strain to the quantum well layer 184.

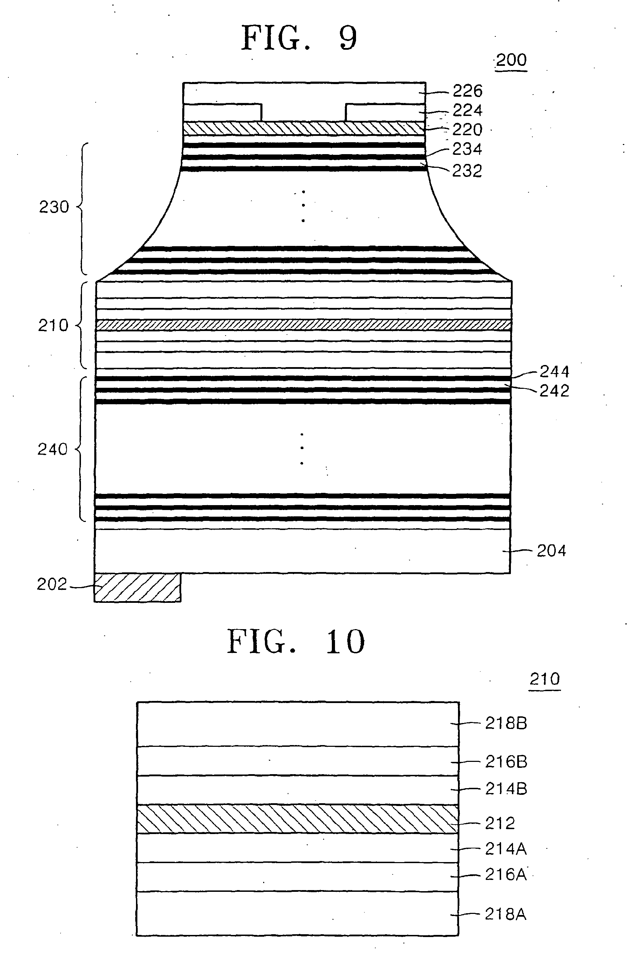

FIG. 9 is a cross-sectional view illustrating a vertical cavity surface emitting laser (VCSEL) according to a fifth embodiment of the present invention. As shown in FIG. 9, a vertical cavity surface emitting laser 200 according to another embodiment of the present invention includes a semiconductor substrate 204, an n-type electrode 202 formed on a lower surface of the semiconductor substrate 204, an n-type distributed Bragg reflector (DBR) layer 240 formed on an upper surface of the semiconductor substrate 204, an active region 210 formed on the n-type DBR layer 240, a p-type DBR layer 230 formed on the active region 210, a contact layer 220 formed on the p-type DBR layer 230, and a p-type electrode 226 formed on the contact layer 220.

In addition, as shown in FIG. 10, the active region 210 includes a central barrier layer 212; a second lower barrier layer 218A, a first lower barrier layer 216A, and a lower quantum well layer 214A, which are sequentially formed between the central barrier layer 212 and the n-type DBR layer 240; and an upper quantum well layer 214B, a first upper barrier layer 216B, and a second upper barrier layer 218B, which are sequentially formed between the central barrier layer 212 and the p-type DBR layer 230.

According to the fifth embodiment of the present invention, the semiconductor substrate 204 is made of an n-type GaAs-based semiconductor material. The n-type BR layer 240 is formed by alternating a plurality of GaAs layers 242 and a plurality of AlGaAs layers 244. The p-type DBR layer 230 is formed by alternating stacking a plurality of GaAs layers 232 and a plurality of AlGaAs layers 234.

The contact layer 220 is made of a p-type material, for example, GaAs, to a thickness of 80 nm (800 Å). The n-type electrode 202 is made of AuGe, and the p-type electrode 226 is made of Ti.

The VCSEL 200 according to the fifth embodiment of the present invention is a striped type. In order to allow a current to be applied to striped regions of the active region 210 from the p-type electrode 226, an insulating layer 224 is formed of SiO₂ on the contact layer 220 and patterned into stripes.

Although not illustrated in the drawings, in order to improve an ohmic contact between the p-type electrode 226 and the p-type contact layer 220, a metal contact layer formed of Ti or Pt or as a stack of Ti and Pt layers may be further formed. Also, in order to also improve an ohmic contact between the n-type electrode 202 and the semiconductor substrate 204, a metal contact layer formed of Ni or Au or as a stack of Ni and Au layers may be further included.

The active region 210 shown in FIG. 10 has the same structure and function as the active region 110 according to the first embodiment of the present invention.

Although the VCSEL according to the fifth embodiment of the present invention is described in connection with the active region 210, a VCSEL may be implemented using any one of the active regions according to the second through fourth embodiments described above.

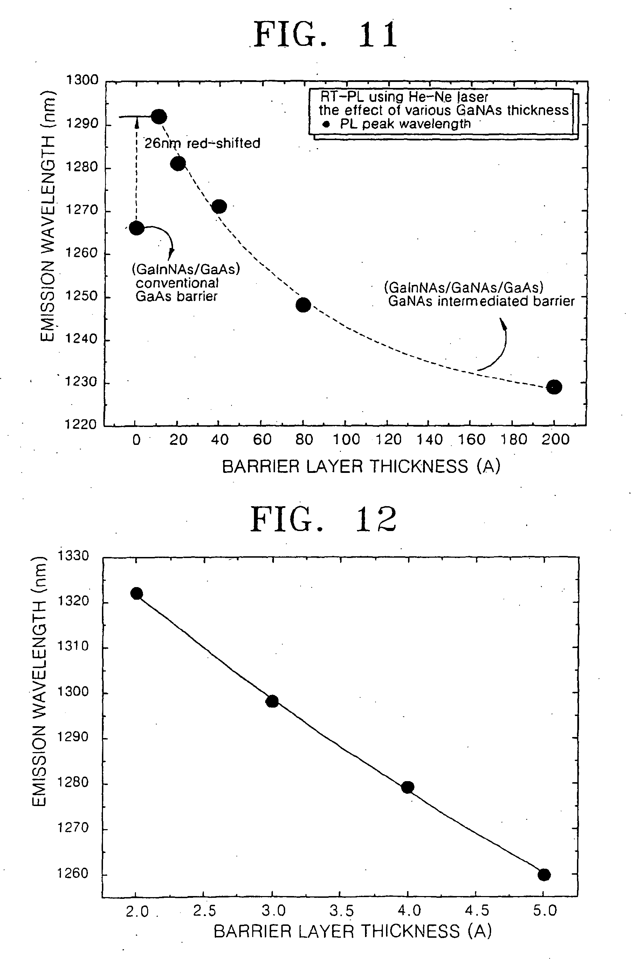

FIG. 11 is a graph of an emission wavelength versus barrier layer thickness in a quantum well structure according to the present invention, which includes a first barrier layer made of InGaAs and a second barrier layer made of GaNAs, when the thickness of the first barrier layer is fixed and the thickness of the second barrier layer is varied. The emission wavelength was measured using photoluminescence (PL) at room temperature. As is apparent from the graph of FIG. 11, the emission wavelength emitted from the quantum well is shifted toward a red wavelength range as the thickness of the GaNAs layer is reduced. Comparing to a conventional semiconductor laser including a GaAs barrier layer in a GaInNAs quantum well structure, red-shifting up to about 25 nm has occurred.

FIG. 12 is a graph illustrating change of emission wavelength in a quantum well when the thickness of the second barrier layer made of GaNAs is fixed and the thickness of the first barrier layer made of InGaAs is varied. As is apparent from the graph of FIG. 12, the emission wavelength is shifted toward a longer wavelength range, up to 60 nm, as the thickness of the InGaAs layer is reduced.

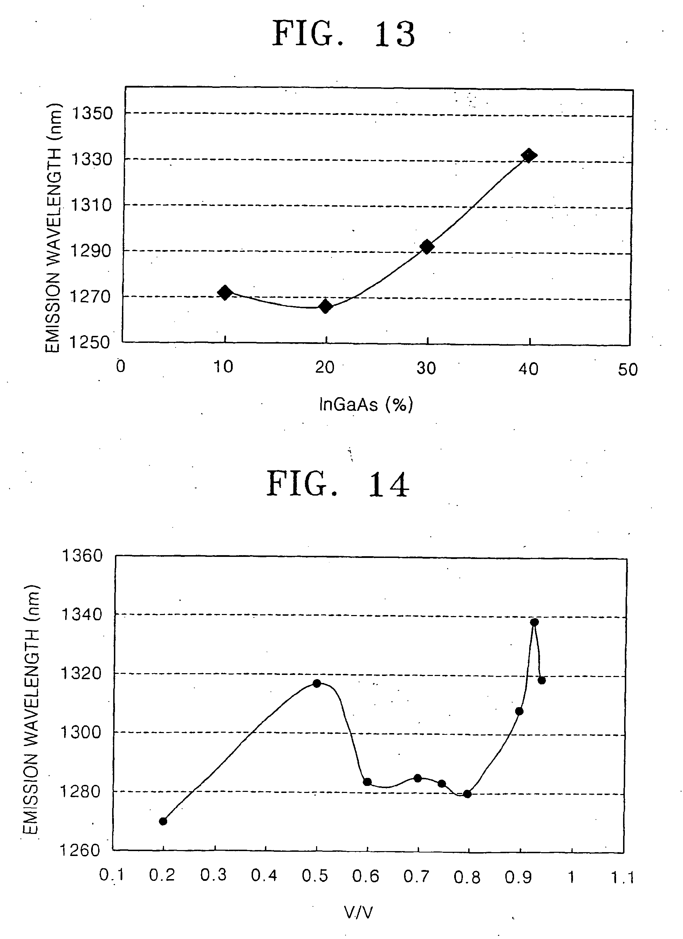

FIG. 13 is a graph of an emission wavelength in quantum well versus the amount of indium in an InGaAs layer. The graph of FIG. 13 was experimentally obtained using a structure including a central barrier layer made of Ga_{0.015}As_{0.985} and first (GaNAs) and second (InGaAs) barrier layers, which have fixed thicknesses. As is apparent from FIG. 13, the emission wavelength becomes shortest when 20% of In is used.

FIG. 14 is a graph of an emission wavelength in quantum well versus the amount of nitrogen (N) in the second barrier layer made of GaNAs. The graph of FIG. 14 was experimentally obtained using a structure including a first barrier layer made of In_{0.35}Ga_{0.65}As, in which the first (InGaAs) and second (GaNAs) barrier layers have fixed thicknesses, while varying a DMHY flow rate.

As described above, according to the present invention, by forming a plurality of barrier layers in a quantum well structure and by adjusting the thickness and composition of each of the barrier layers, a problem of optical quality degradation in a long wavelength range, which arises with conventional quantum well structures, can be solved.

According to the present invention, emission wavelength shifting to a shorter wavelength range, which occurs when a GaInNAs quantum well structure is thermally treated, can be prevented.

According to the present invention, using a GaAs-based quantum well structure, an emission wavelength of 1.3 µm or longer can be easily generated.

According to the present invention, use of the first barrier layer made of InGaAs layer to induce compressive strain to the quantum well structure is advantageous in terms of optical gain.

According to the present invention, long-wavelength emission can be economically achieved using a small amount of nitrogen MO source.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A semiconductor laser device comprising:
a GaAs-based substrate; and
a quantum well structure formed on the GaAs-based substrate and including a quantum well layer (114a, 114b, 214a, 214b), a pair of first barrier layers (116a, 116b, 216a, 216b) facing each other with the quantum well layer (114a, 114b, 214a, 214b) therebetween, and a pair of second barrier layers (118a, 118b) adjacent to the respective first barrier layers (116a, 116b, 216a, 216b) on the other side of the first barrier layers to the quantum well layer;
wherein the quantum well layer (114a, 114b, 214a, 214b) contains GaₓIn₁₋ₓN_{y}As_{1-y} where x and y are greater than 0 and smaller than 1;
**characterised in that** the first barrier layers (116a, 116b) contain InₓGa₁₋ₓAs where x is greater than 0 and smaller than 1, wherein compressive strain is induced in the quantum well layer by the first barrier layers; and
the second barrier layers (118a, 118b) contain GaNₓAs₁₋ₓ where x is greater than 0 and smaller than 1, wherein tensile strain is induced in the quantum well layer by the second barrier layers.

2. The semiconductor laser device according to claim 1, wherein the thicknesses and compositions of the first barrier layers (116a, 116b, 216a, 216b) and the second barrier layers (118a, 118b, 218a, 218b) are adapted to generate a predetermined wavelength of light in the quantum well structure.

3. The semiconductor laser device according to claim 1 or 2, wherein each of the first barrier layers (116a, 116b, 216a, 216b) has a thickness ranging from 0.1 nm to 50 nm.

4. The semiconductor laser device according to claim 1, 2 or 3, wherein each of the second barrier layers (118a, 118b, 218a, 218b) has a thickness ranging from 0.1 nm to 50 nm.

5. The semiconductor laser device according to any preceding claim, wherein the quantum well layer is a multi-quantum well layer comprising a plurality of well layers (114a, 114b) composed of GaInNAs and at least one barrier layer (112) alternating with the well layers.

6. The semiconductor laser device according to claim 5, wherein each of the well layers (114a, 114b) has a thickness ranging from 2 nm to 10 nm.

7. The semiconductor laser device according to any preceding claim, wherein the compressive strain of the quantum well layer (114a, 114b, 214a, 214b) is controlled by adjusting the amount of In in the first barrier layers, and the tensile strain of the quantum well layer is controlled by adjusting the amount of N in the second barrier layers.

8. An edge-emitting semiconductor laser according to any preceding claim further comprising:
a cladding layer (106) surrounding the quantum well structure; and
a pair of electrodes (102, 126) electrically connected to the cladding layer.

9. A vertical cavity surface emitting laser according to any of claims 1 to 8 comprising:
a first distributed Bragg reflection (DBR) region (240) formed on the GaAs-based substrate, the quantum well structure being formed on the first DBR region;
a second DBR region (230) formed on the quantum well structure; and
a pair of electrodes (202, 226) electrically connected to the first and second DBR regions.

10. The vertical cavity surface emitting laser according to any preceding claim, wherein each of the second barrier layers has a thickness ranging from 5 nm to 50 nm.

11. A method of manufacturing a semiconductor laser device, the method comprising:
preparing a GaAs-based substrate;
forming a second lower barrier layer (118a, 218a) on the GaAs-based substrate;
forming a first lower barrier layer (116a, 216a) on the second lower barrier layer;
forming a quantum well layer (114a, 114b, 214a, 214b) on the first lower barrier layer;
forming a first upper barrier layer (116b, 216b) on the quantum well structure; and
forming a second upper barrier layer (118b, 218b) on the first upper barrier layer;
wherein the quantum well layer (114a, 114b, 214a, 214b) contains GaₓIn₁₋ₓN_{y}As_{1-y} where x and y are greater than 0 and smaller than 1;
**characterised in that** the first barrier layers (116a, 116b) contain InₓGa₁₋ₓAs where x is greater than 0 and smaller than 1, wherein compressive strain is induced in the quantum well layer by the first barrier layers; and
the second barrier layers (118a, 118b, 218a, 218b) contain GaNₓAs₁₋ₓ where x is greater than 0 and smaller than 1, wherein tensile strain is induced in the quantum well layer by the second barrier layers.

12. The method according to claim 11, wherein the quantum well layer has a thickness ranging from 2 nm to 10 nm.

13. The method according to any of claims 11 to 12, wherein each of the first lower and upper barrier layers (116a, 116b, 216a, 216b) has a thickness ranging from 0.1 nm to 50 nm.

14. The method according to any of claims 11 to 13, wherein each of the second lower and upper barrier layers (118a, 118b, 218a, 218b) has a thickness ranging from 0.1 nm to 50 nm.

## Patentansprüche

1. Halbleiterlaserbauelement umfassend:
ein Substrat auf GaAs-Basis und
eine Quantentopfstruktur, die auf dem Substrat auf GaAs-Basis gebildet ist und eine Quantentopfschicht (114a, 114b, 214a, 214b), ein Paar erster Barriereschichten (116a, 116b, 216a, 216b), die einander mit der dazwischen angeordneten Quantentopfschicht (114a, 114b, 214a, 214b) gegenüberstehen, und ein Paar zweiter Barriereschichten (118a, 118b) angrenzend an die zugehörigen ersten Barriereschichten (116a, 116b, 216a, 216b) auf der anderen Seite der ersten Barriereschichten an der Quantentopfschicht aufweist,
wobei die Quantentopfschicht (114a, 114b, 214a, 214b) GaₓIn₁₋ₓN_{y}As_{1-y} enthält, wobei x und y größer als 0 und kleiner als 1 sind,
**dadurch gekennzeichnet, dass** die ersten Barriereschichten (116a, 116b) InₓGa₁₋ₓAs enthalten, wobei x größer als 0 und kleiner als 1 ist,
wobei durch die ersten Barriereschichten in der Quantentopfschicht eine Druckbelastung induziert wird, und
die zweiten Barriereschichten (118a, 118b) GaNₓAs₁₋ₓ enthalten, wobei x größer als 0 und kleiner als 1 ist, wobei durch die zweiten Barriereschichten in der Quantentopfschicht eine Zugbelastung induziert wird.

2. Halbleiterlaserbauelement nach Anspruch 1, wobei die Dicken und Zusammensetzungen der ersten Barriereschichten (116a, 116b, 216a, 216b) und der zweiten Barriereschichten (118a, 118b, 218a, 218b) so ausgebildet sind, dass sie eine vorgegebene Wellenlänge von Licht in der Quantentopfstruktur erzeugen.

3. Halbleiterlaserbauelement nach Anspruch 1 oder 2, wobei jede der ersten Barriereschichten (116a, 116b, 216a, 216b) eine Dicke im Bereich von 0,1 nm bis 50 nm aufweist.

4. Halbleiterlaserbauelement nach Anspruch 1, 2 oder 3, wobei jede der zweiten Barriereschichten (118a, 118b, 218a, 218b) eine Dicke im Bereich von 0,1 nm bis 50 nm aufweist.

5. Halbleiterlaserbauelement nach einem der vorhergehenden Ansprüche, wobei die Quantentopfschicht eine Mehrquantentopfschicht ist, die eine Mehrzahl von Topfschichten (114a, 114b) umfasst, die aus GaInNAs und mindestens einer Barriereschicht (112), die mit den Topfschichten abwechseln, gebildet ist.

6. Halbleiterlaserbauelement nach Anspruch 5, wobei jede der Topfschichten (114a, 114b) eine Dicke im Bereich von 2 nm bis 10 nm aufweist.

7. Halbleiterlaserbauelement nach einem der vorhergehenden Ansprüche, wobei die Druckbelastung der Quantentopfschicht (114a, 114b, 214a, 214b) durch Einstellen der Menge an In in den ersten Barriereschichten gesteuert ist und die Zugbelastung der Quantentopfschicht durch Einstellen der Menge an N in den zweiten Barriereschichten gesteuert ist.

8. Kantenemittierendes Halbleiterlaserbauelement nach einem der vorhergehenden Ansprüche, ferner umfassend:
eine Auskleidungsschicht (106), die die Quantentopfstruktur umgibt, und
ein Paar Elektroden (102, 126), die mit der Auskleidungsschicht elektrisch verbunden sind.

9. Vertical-Cavity-Surface-Emitting-Laser (VCSEL) nach einem der Ansprüche 1 bis 8, umfassend:
einen ersten verteilten Bragg-Reflexions(DBR)-Bereich (240), der auf dem Substrat auf GaAs-Basis gebildet ist, wobei die Quantentopfstruktur auf dem ersten DBR-Bereich gebildet ist,
einen zweiten DBR-Bereich (230), der auf der Quantentopfstruktur gebildet ist, und
ein Paar Elektroden (202, 226), die mit dem ersten und zweiten DBR-Bereich elektrisch verbunden sind.

10. VCSEL-Laser nach einem der vorhergehenden Ansprüche, wobei jede der zweiten Barriereschichten eine Dicke im Bereich von 5 nm bis 50 nm aufweist.

11. Verfahren zur Herstellung eines Halbleiterlaserbauelements, wobei das Verfahren umfasst:
Vorbereiten eines Substrats auf GaAs-Basis,
Ausbilden einer zweiten unteren Barriereschicht (118a, 218a) auf dem Substrat auf GaAs-Basis,
Ausbilden einer ersten unteren Barriereschicht (116a, 216a) auf der zweiten unteren Barriereschicht,
Ausbilden einer Quantentopfschicht (114a, 114b, 214a, 214b) auf der ersten unteren Barriereschicht,
Ausbilden einer ersten oberen Barriereschicht (116b, 216b) auf der Quantentopfstruktur und
Ausbilden einer zweiten oberen Barriereschicht (118b, 218b) auf der ersten oberen Barriereschicht,
wobei die Quantentopfschicht (114a, 114b, 214a, 214b) GaₓIn₁₋ₓNyAs_{1-y} enthält, wobei x und y größer als 0 und kleiner als 1 sind,
**dadurch gekennzeichnet, dass** die ersten Barriereschichten (116a, 116b) InₓGa₁₋ₓAs enthalten, wobei x größer als 0 und kleiner als 1 ist,
wobei durch die ersten Barriereschichten in der Quantentopfschicht eine Druckbelastung induziert wird, und
die zweiten Barriereschichten (118a, 118b, 218a, 218b) GaNₓAs₁₋ₓ enthalten, wobei x größer als 0 und kleiner als 1 ist, wobei durch die zweiten Barriereschichten in der Quantentopfschicht eine Zugbelastung induziert wird.

12. Verfahren nach Anspruch 11, wobei die Quantentopfschicht eine Dicke im Bereich von 2 nm bis 10 nm aufweist.

13. Verfahren nach einem der Ansprüche 11 bis 12, wobei jede der ersten unteren und oberen Barriereschichten (116a, 116b, 216a, 216b) eine Dicke im Bereich von 0,1 nm bis 50 nm aufweist.

14. Verfahren nach einem der Ansprüche 11 bis 13, wobei jede der zweiten unteren und oberen Barriereschichten (118a, 118b, 218a, 218b) eine Dicke im Bereich von 0,1 nm bis 50 nm aufweist.

## Revendications

1. Dispositif de diode laser, comprenant :
un substrat à base de GaAs ; et
une structure de puits quantique formée sur le substrat à base de GaAs et comprenant une couche de puits quantique (114a, 114b, 214a, 214b), une paire de premières couches barrières (116a, 116b, 216a, 216b) face à face avec la couche de puits quantique (114a, 114b, 214a, 214b) située entre elles et une paire de secondes couches barrières (118a, 118b) adjacentes aux premières couches barrières respectives (116a, 116b, 216a, 216b) sur l'autre côté des premières couches barrières vers la couche de puits quantique ;
dans lequel la couche de puits quantique (114a, 114b, 214a, 214b) contient GaₓIn₁₋ₓN_{y}As_{1-y} où x et y sont supérieurs à 0 et inférieurs à 1 ;
**caractérisé en ce que** les premières couches barrières (116a, 116b) contiennent InₓGa₁₋ₓAs où x est supérieur à 0 et inférieur à 1, dans lequel une contrainte de compression est induite dans la couche de puits quantique par les premières couches barrières ; et
les secondes couches barrières (118a, 118b) contiennent GaNₓAs₁₋ₓ où x est supérieur à 0 et inférieur à 1, dans lequel une contrainte de traction est induite dans la couche de puits quantique par les secondes couches barrières.

2. Dispositif de diode laser selon la revendication 1, dans lequel les épaisseurs et les compositions des premières couches barrières (116a, 116b, 216a, 216b) et des secondes couches barrières (118a, 118b, 218a, 218b) sont adaptées pour générer une longueur d'onde de lumière prédéterminée dans la structure de puits quantique.

3. Dispositif de diode laser selon la revendication 1 ou 2, dans lequel chacune des premières couches barrières (116a, 116b, 216a, 216b) a une épaisseur allant de 0,1 nm à 50 nm.

4. Dispositif de diode laser selon la revendication 1, 2 ou 3, dans lequel chacune des secondes couches barrières (118a, 118b, 218a, 218b) a une épaisseur allant de 0,1 nm à 50 nm.

5. Dispositif de diode laser selon l'une quelconque des revendications précédentes, dans lequel la couche de puits quantique est une multicouche de puits quantique contenant une pluralité de couches de puits (114a, 114b) composées de GaInNAs et au moins une couche barrière (112) en alternance avec les couches de puits.

6. Dispositif de diode laser selon la revendication 5, dans lequel chacune des couches de puits (114a, 114b) a une épaisseur allant de 2 nm à 10 nm.

7. Dispositif de diode laser selon l'une quelconque des revendications précédentes, dans lequel la contrainte de compression de la couche de puits quantique (114a, 114b, 214a, 214b) est commandée par le réglage de la quantité de In dans les premières couches barrières et la contrainte de traction de la couche de puits quantique est commandée par le réglage de la quantité de N dans les secondes couches barrières.

8. Diode laser à émission latérale selon l'une quelconque des revendications précédentes, comprenant en outre :
une couche de placage (106) entourant la structure de puits quantique ; et
une paire d'électrodes (102, 126) électriquement reliées à la couche de placage.

9. Laser à émission par la surface selon l'une quelconque des revendications 1 à 8, comprenant :
une première région de réflexion de Bragg distribuée (DBR) (240) formée sur le substrat à base de GaAs, la structure de puits quantique étant formée sur la première région DBR ;
une seconde région DBR (230) formée sur la structure de puits quantique ; et
une paire d'électrodes (202, 226) électriquement reliées aux première et seconde régions DBR.

10. Laser à émission par la surface selon l'une quelconque des revendications précédentes, dans lequel chacune des secondes couches barrières a une épaisseur allant de 5 nm à 50 nm.

11. Procédé de fabrication d'un dispositif de diode laser, le procédé comprenant :
la préparation d'un substrat à base de GaAs ;
la formation d'une seconde couche barrière inférieure (118a, 218a) sur le substrat à base de GaAs ;
la formation d'une première couche barrière inférieure (116a, 216a) sur la seconde couche barrière inférieure ;
la formation d'une couche de puits quantique (114a, 114b, 214a, 214b) sur la première couche barrière inférieure ;
la formation d'une première couche barrière supérieure (116b, 216b) sur la structure de puits quantique ; et
la formation d'une seconde couche barrière supérieure (118b, 218b) sur la première couche barrière supérieure ;
dans lequel la couche de puits quantique (114a, 114b, 214a, 214b) contient GaₓIn₁₋ₓN_{y}As_{1-y} où x et y sont supérieurs à 0 et inférieurs à 1 ;
**caractérisé en ce que** les premières couches barrières (116a, 116b) contiennent InₓGa₁₋ₓAs où x est supérieur à 0 et inférieur à 1, dans lequel une contrainte de compression est induite dans la couche de puits quantique par les premières couches barrières ; et
les secondes couches barrières (118a, 118b, 218a, 218b) contiennent GaNₓAs₁₋ₓ où x est supérieur à 0 et inférieur à 1, dans lequel une contrainte de traction est induite dans la couche de puits quantique par les secondes couches barrières.

12. Procédé selon la revendication 11, dans lequel la couche de puits quantique a une épaisseur allant de 2 nm à 10 nm.

13. Procédé selon l'une quelconque des revendications 11 à 12, dans lequel chacune des premières couches barrières inférieures et supérieures (116a, 116b, 216a, 216b) a une épaisseur allant de 0,1 nm à 50 nm.

14. Procédé selon l'une quelconque des revendications 11 à 13, dans lequel chacune des secondes couches barrières inférieures et supérieures (118a, 118b, 218a, 218b) a une épaisseur allant de 0,1 nm à 50 nm.
